# EUROPEAN PATENT APPLICATION

(11) **EP 1 944 800 A2**
(43) Date of publication of application: **16.07.2008**
(21) Application number: 07024203.7
(22) Date of filing: 13.12.2007
(51) Int. Cl.: H01L 21/687

(54) **Method for manufacturing substrate mounting table**

(30) Priority: 15.12.2006 JP 2006337684
(71) Applicant: Tokyo Electron Ltd., Tokyo 107-8481 (JP)
(72) Inventor: Nagayama, Nobuyuki, Tokyo 107-8481 (JP); Ueda, Takehiro, Tokyo 107-8481 (JP); Kobayashi, Yoshiyuki, Tokyo 107-8481 (JP); Oohashi, Kaoru, Tokyo 107-8481 (JP)
(74) Representative: HOFFMANN EITLE

(57) **Abstract**

A method for manufacturing a substrate mounting table having a mounting surface for mounting a substrate thereon; a plurality of gas injection openings opened on the mounting surface to supply a gas toward the mounting surface; a gas supply channel for supplying a gas to the gas injection openings; and a thermally sprayed ceramic layer covering the mounting surface is provided. The method includes forming a removable film at least on inner wall portions of the gas supply channel facing the gas injection openings; forming the thermally sprayed ceramic layer on the mounting surface; and removing the film.

## Description

The present invention relates to a manufacturing method for a substrate mounting table; and, more particularly, to a manufacturing method for a substrate mounting table suitable for a plasma processing of a semiconductor substrate or the like.

Conventionally, there has been known a substrate processing apparatus for performing a plasma process such as plasma etching on, e.g., a semiconductor substrate wherein a substrate mounting table for mounting the substrate thereon is provided with a fluid supply mechanism for supplying a cooling gas such as a helium gas to a rear surface side of the substrate. Further, it is also known that a thermally sprayed ceramic layer such as an Al₂O₃ layer is formed on a substrate mounting surface of the substrate mounting table as an insulating layer which forms an electrostatic chuck (see, for example, Japanese Patent Laid-open Application No. 2004-47653).

In the course of manufacturing the aforementioned substrate mounting table, thermally sprayed ceramic may enter a gas supply channel through gas injection openings provided in a mounting surface. Thus, it is required to perform a cleaning process to wash off the ceramic that has entered the inside of the gas supply channel and adhered to, for example, a bottom portion thereof.

According to thorough investigation, however, the present inventors have founded that the thermally sprayed ceramic firmly stuck to, for example, the bottom portion of the gas supply channel may not be removed completely through the cleaning process, and some may remain as spray residue. If this spray residue is peeled off while a final product is in use, it would contaminate a semiconductor wafer or the inside of a processing chamber, or clog up the gas supply openings, resulting in a pressure reduction of a cooling gas and a failure in temperature control.

In view of the above, the present invention provides a manufacturing method for a substrate mounting table, capable of suppressing spray residue from being left in a fluid supply channel, thus preventing contamination by the spray residue and clogging-up of the fluid supply channel with the spray residue.

In accordance with an aspect of the present invention, there is provided a method for manufacturing a substrate mounting table including a mounting surface for mounting a substrate thereon; a plurality of gas injection openings opened on the mounting surface to supply a gas toward the mounting surface; a gas supply channel for supplying a gas to the gas injection openings; and a thermally sprayed ceramic layer covering the mounting surface, the method including:
forming a removable film at least on inner wall portions of the gas supply channel facing the gas injection openings;
forming the thermally sprayed ceramic layer on the mounting surface; and
removing the film.

Preferably, in forming the thermally sprayed ceramic layer, ceramic is thermally sprayed on the mounting surface while discharging a compressed gas from the gas injection openings.

Preferably, the gas supply channel is shared by the gas injection openings.

Preferably, the film is made of acrylic resin.

Preferably, in removing the film, the film is removed by using an organic solvent.

Preferably, the organic solvent is acetone.

Preferably, the method further includes preparing in the gas supply channel a plurality of cleaning openings for introducing into or exhausting from the gas supply channel a cleaning fluid, wherein in removing the film, the cleaning fluid is introduced into or exhausted from the gas supply channel through the cleaning openings.

In accordance with the embodiment of the present invention, a manufacturing method for a substrate mounting table, capable of suppressing spray residue from being left in a fluid supply channel, thus preventing contamination by the spray residue and clogging-up of the fluid supply channel with the spray residue, can be provided.

The above features of the present invention will become apparent from the following description of an embodiment given in conjunction with the accompanying drawings, in which:
Fig. 1 illustrates a schematic configuration view of a plasma etching apparatus in accordance with an embodiment of the present invention;
Fig. 2 illustrates an enlarged cross sectional configuration view of major parts of a substrate mounting table in accordance with the embodiment of the present invention;
Fig. 3 illustrates a top surface configuration view of a first plate shaped member of the substrate mounting table of Fig. 2;
Fig. 4 illustrates a bottom surface configuration view of the first plate shaped member of Fig. 3;
Fig. 5 illustrates a top surface configuration view of a second plate shaped member of the substrate mounting table of Fig. 2;
Fig. 6 illustrates a flowchart for describing a manufacturing process of the substrate mounting table in accordance with the embodiment of the present invention; and
Figs. 7A to 7D respectively illustrate diagrams for describing the manufacturing process of the substrate mounting table of Fig. 6.

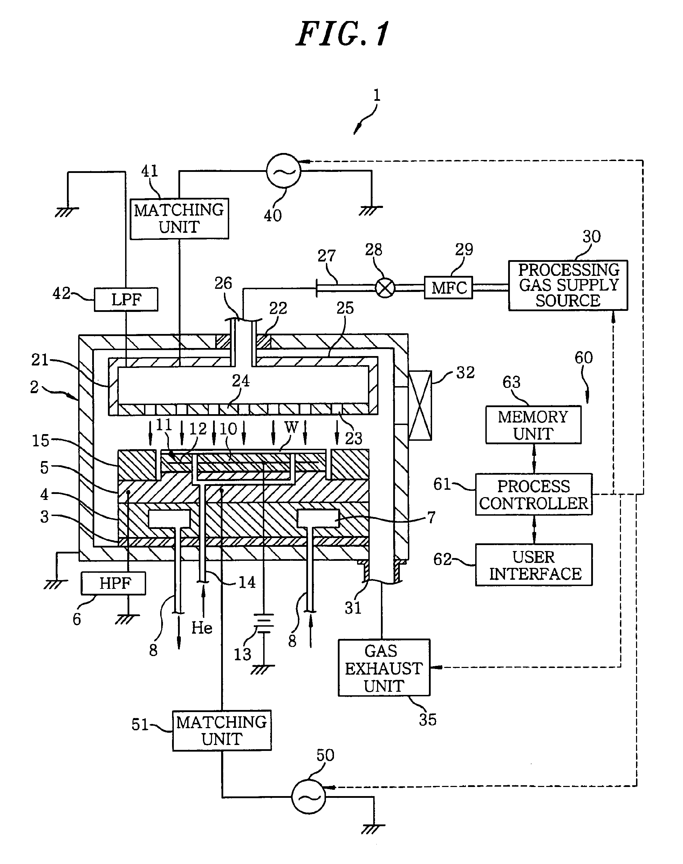

Hereinafter, an embodiment of the present invention will be described in detail with reference to the accompanying drawings, which form a part hereof. Fig. 1 illustrates a cross sectional configuration view of a plasma etching apparatus 1 which is employed as a plasma processing apparatus including a substrate mounting table in accordance with the present embodiment. Below, the configuration of the plasma etching apparatus 1 will be first explained with reference to Fig. 1.

The plasma etching apparatus 1 is configured as a capacitively coupled parallel plate type etching apparatus having an upper and a lower electrode plate placed to face each other in parallel and respectively connected to power supplies for plasma generation.

The plasma etching apparatus 1 has a cylindrical processing chamber (processing vessel) 2 formed of, for example, aluminum whose surface is anodically oxidized, and the processing chamber 2 is grounded. A substantially columnar susceptor support 4 for mounting thereon a target object to be processed, e.g., a semiconductor wafer W, is installed at a bottom portion of the processing chamber 2 via an insulating plate 3 such as ceramic. Further, a substrate mounting table (susceptor) 5 serving as a lower electrode is mounted on the susceptor support 4, and the substrate mounting table 5 is connected to a high pass filter (HPF) 6. A detailed configuration of the substrate mounting table 5 will be explained later.

A coolant path 7 is formed inside the susceptor support 4, and a coolant is introduced into the coolant path 7 via a coolant introducing line 8 to be circulated therethrough. By the circulation of the coolant through the coolant path 7, the cold heat of the coolant is transferred to the semiconductor wafer W via the substrate mounting table 5, whereby the semiconductor wafer W is regulated at a desired temperature level.

The substrate mounting table 5 is of a circular plate shape with an upper central portion protruded higher than its peripheral portion, and an electrostatic chuck 11 that is shaped substantially identical to the semiconductor wafer W is disposed on the upper central portion of the substrate mounting table 5. The electrostatic chuck 11 includes an electrode 12 embedded in an insulating member (made of a thermally sprayed ceramic film) 10. The semiconductor wafer W is electrostatically attracted to the electrostatic chuck 11 by, for example, a Coulomb force generated by applying a DC voltage of, for example, 1.5 kV to the electrode 12 from a DC power supply 13 connected thereto.

Further, formed through the insulating plate 3, the susceptor support 4, the substrate mounting table 5 and the electrostatic chuck 11 is a gas channel 14 for supplying a heat transfer medium (e.g., a He gas) to the rear surface of the semiconductor wafer W. Thus, the cold heat of the substrate mounting table 5 is transferred to the semiconductor wafer W through the heat transfer medium, so that the wafer W is maintained at a specific temperature level.

An annular focus ring 15 is disposed on the periphery of the top surface of the substrate mounting table 5 to surround the semiconductor wafer W loaded on the electrostatic chuck 11. The focus ring 15 is formed of a conductive material such as silicon and serves to improve uniformity of etching.

An upper electrode 21 is disposed above the substrate mounting table 5, while facing it in parallel. The upper electrode 21 is supported at an upper portion of the processing chamber 2 via an insulating member 22. The upper electrode 21 includes an electrode plate 24; and an electrode support 25 that serves to support the electrode 24 and is formed of a conductive material. The electrode plate 24 is configured to face the substrate mounting table 5 and is provided with a number of gas injection openings 23. The electrode plate 24 is formed of, for example, silicon or aluminum whose surface is anodically oxidized (alumite treated) with a quartz cover attached thereto. A distance between the substrate mounting table 5 and the upper electrode 21 is variable.

A gas inlet port 26 is formed at a center of the electrode support 25 of the upper electrode 21, and a gas supply line 27 is coupled to the gas inlet port 26. Further, the gas supply line 27 is connected to a processing gas supply source 30 via a valve 28 and a mass flow controller 29.

A gas exhaust line 31 is connected to a bottom portion of the chamber 2, and a gas exhaust unit 35 is coupled to the gas exhaust line 31. The gas exhaust unit 35 includes a vacuum pump such as a turbo molecular pump, and serves to create a depressurized atmosphere in the processing chamber 2, i.e., to evacuate the processing chamber 2 such that the internal pressure thereof is reduced down to a specific vacuum level, e.g., 1 Pa or less. Further, a gate valve 32 is installed at a sidewall of the processing chamber 2. The semiconductor wafer W is transferred between the processing chamber 2 and an adjacent load lock chamber (not shown) while the gate valve 32 is opened.

A first high frequency power supply 40 is connected to the upper electrode 21 via a matching unit 41. Further, a low pass filter (LPF) 42 is connected to the upper electrode 21. The first high frequency power supply 40 has a frequency range from about 50 to 150 MHz. By applying a high frequency power in such a high frequency range, a high-density plasma in a desirable dissociated state can be generated in the processing chamber 2.

Further, a second high frequency power supply 50 is connected to the substrate mounting table 5 serving as the lower electrode via a matching unit 51. The second high frequency power supply 50 has a frequency range lower than that of the first high frequency power supply 40. By applying a power of a frequency in such a range, a proper ionic action can be facilitated without causing any damage on the semiconductor wafer W, which is an object being processed. Preferably, the frequency of the second high frequency power supply 50 is determined within a range from about 1 to 20 MHz.

The whole operation of the plasma etching apparatus 1 having the above-described configuration is controlled by a control unit 60. The control unit 60 includes a process controller 61 having a CPU for controlling each component of the plasma etching apparatus 1; a user interface 62; and a memory unit 63.

The user interface 62 includes a keyboard for a process manager to input a command to manipulate the plasma etching apparatus 1; a display for visualizing an operational status of the plasma etching apparatus 1; and the like.

The memory unit 63 stores therein recipes including control programs (softwares), processing condition data and the like to be used in realizing various processes, which are performed in the plasma etching apparatus 1 under the control of the process controller 61. When a command is received from the user interface 62, a necessary recipe is retrieved from the memory unit 63 and is executed by the process controller 61, whereby a desired process is performed in the plasma etching apparatus 1 under the control of the process controller 61. The necessary recipes including control programs, processing condition data and the like can be retrieved from a computer-readable storage medium (e.g., a hard disk, a CD, a flexible disk, a semiconductor memory, and the like), or can be transmitted from another apparatus via, e.g., a dedicated line, if necessary.

When a semiconductor wafer W is plasma etched by the plasma etching apparatus 1 configured as described above, the gate valve 32 is opened first, and then the semiconductor wafer W is loaded into the processing chamber 2 from the load lock chamber (not shown) and mounted on the electrostatic chuck 11. Then, a DC voltage is applied from the DC power supply 13, whereby the semiconductor wafer W is electrostatically attracted to the electrostatic chuck 11 to be held thereon. Subsequently, the gate valve 32 is closed, and the processing chamber 2 is evacuated to a specific vacuum level by the gas exhaust unit 35.

Thereafter, the valve 28 is opened, and a processing gas (etching gas) is supplied from the processing gas supply source 30 into a hollow space of the upper electrode 21 via the gas supply line 27 and the gas inlet port 26 while its flow rate is controlled by the mass flow controller 29. Then, the processing gas is discharged uniformly toward the semiconductor wafer W through the injection openings 23 of the electrode plate 24, as indicated by arrows in Fig. 1.

Then, the internal pressure of the processing chamber 2 is maintained at a specific pressure level, and then a high frequency power of a specific frequency is applied to the upper electrode 21 from the first high frequency power supply 40, whereby a high frequency electric field is generated between the upper electrode 21 and the substrate mounting table 5 serving as the lower electrode. As a result, the processing gas is dissociated and converted into a plasma.

Meanwhile, a high frequency power of a frequency lower than that from the first high frequency power supply 40 is applied to the substrate mounting table 5 serving as the lower electrode from the second high frequency power supply 50. As a result, ions in the plasma are attracted toward the substrate mounting table 5, so that etching anisotropy is improved by ion assist.

Then, upon the completion of the plasma etching, the supply of the high frequency powers and the processing gas is stopped, and the semiconductor wafer W is retreated out of the processing chamber 2 in the reverse sequence as described above.

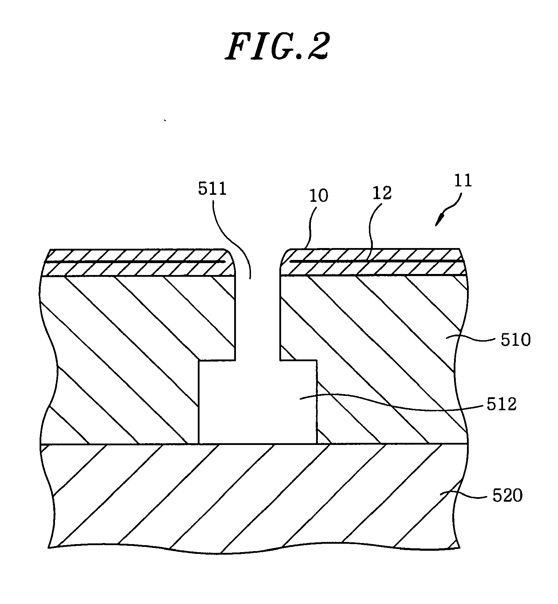

Below, the substrate mounting table (susceptor) 5 in accordance with the embodiment of the present invention will be described in further detail with reference to Figs. 2 to 5. As shown in Figs. 2 to 5, the substrate mounting table 5 includes a first circular plate shaped member 510 and a second circular plate shaped member 520 that are joined to each other to form a circular plate shape as a whole. In the present embodiment, the first plate shaped member 510 and the second plate shaped member 520 are formed of aluminum.

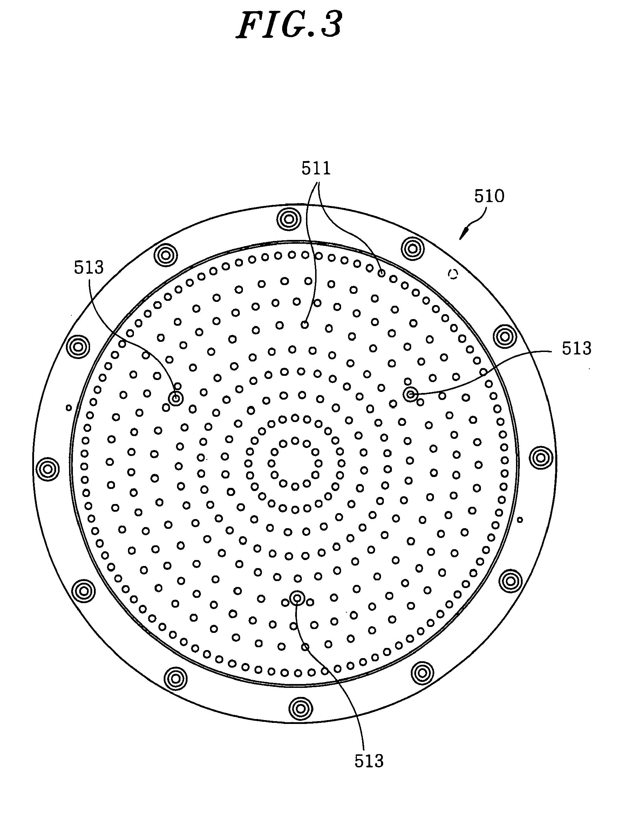

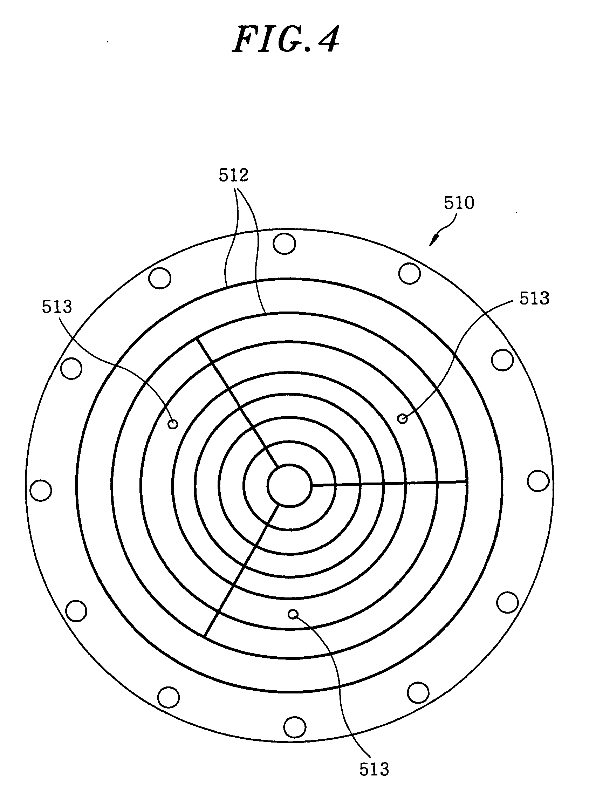

As illustrated in Fig. 3, the first plate shaped member 510 is provided with a plurality of gas injection openings 511. Further, as shown in Fig. 4, the first plate shaped member 510 is provided with grooves 512 concentrically formed to serve as a gas supply channel for supplying a gas to each gas injection opening 511. Among the grooves 512, an outermost groove 512 is shared by a plurality of gas injection openings 511 provided at the outermost portion of the first plate shaped member 510. The rest concentric grooves 512 other than the outermost one and diametrical grooves connecting them are shared by a multiplicity of gas injection openings 511 provided inside the outermost portion of the first plate shaped member 510. With this configuration, it is possible to control a cooling gas pressure for each of the outermost (edge) region and the rest region of the semiconductor wafer W individually. Further, as shown in Figs. 3 and 4, the first plate shaped member 510 has three pin holes 513 which accommodate therein pins for moving the semiconductor wafer W up and down when the semiconductor wafer W is mounted thereon.

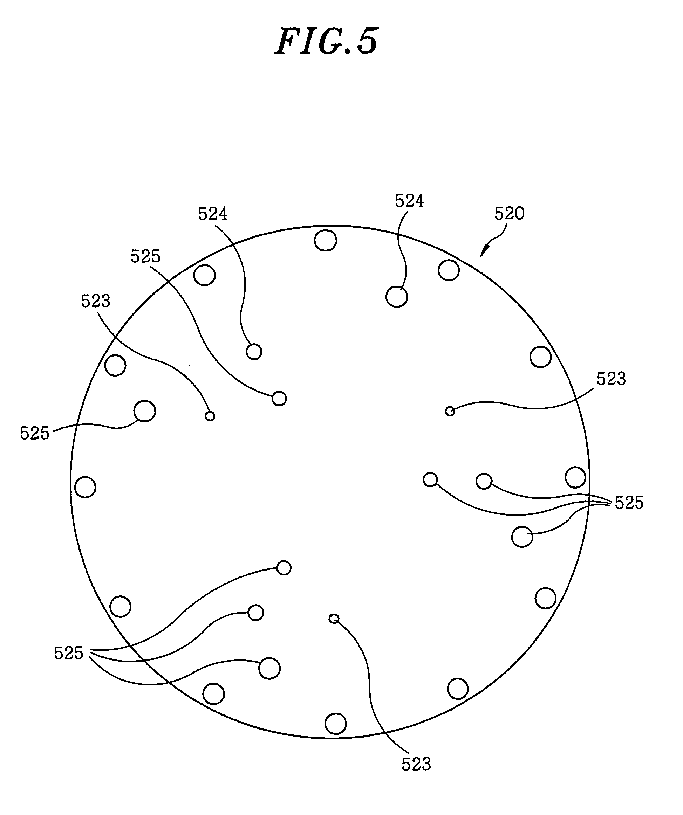

Referring to Fig. 5, the second plate shaped member 520 has a flat surface and has pin holes 523 at locations corresponding to the pin holes 513. Furthermore, as illustrated in Fig. 4, the second plate shaped member 520 is provided with two gas supply openings 524: one for supplying a cooling gas to the outermost groove 512 and the other for supplying the cooling gas to the rest grooves 512. Further, the second plated shaped member 520 is also provided with a plurality (eight in the shown example of Fig. 5) of cleaning openings 525 for use in cleaning the grooves 512. These cleaning openings 525 are used in a cleaning process or the like in a manufacturing process of the substrate mounting table to be described later. When the substrate mounting table 5 is in use, the cleaning openings 525 are closed by clogging members.

Each of the gas injection openings 511 shown in Fig. 2 has a diameter of, e.g., about 1 mm. Meanwhile, each of the grooves 512 shown in Fig. 2 has a width of, e.g., about 3 mm and a depth of, e.g., about 2 mm. These grooves 512 form a gas supply channel through which the cooling gas is supplied to the gas injection openings 511, and the inner walls of the gas supply channel including the inside of the grooves 512 are covered with an anodic oxide film (alumite film, not shown).

Further, as shown in Fig. 2, the electrostatic chuck 11 is disposed on the mounting surface at the top of the first plate shaped member 510. The electrostatic chuck 11 includes the electrode 12 embedded in the insulating member 10 made of a thermally sprayed ceramic film such as an Al₂O₃ film. The electrode 12 is formed of a metal (in the present embodiment, a thermally sprayed tungsten film).

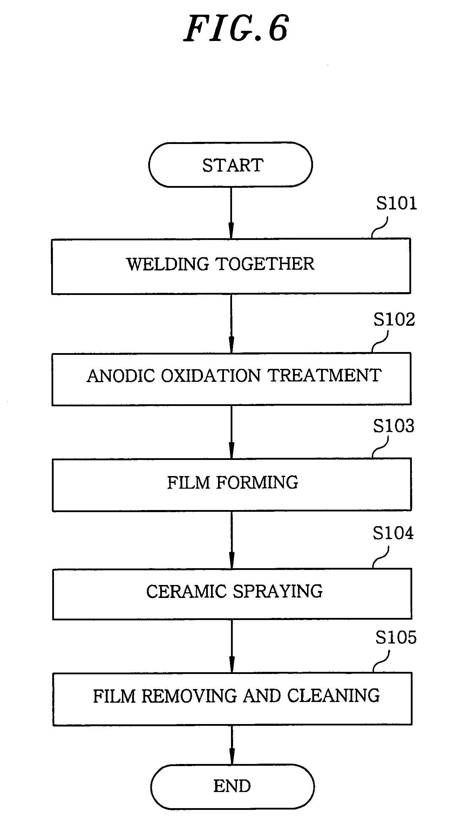

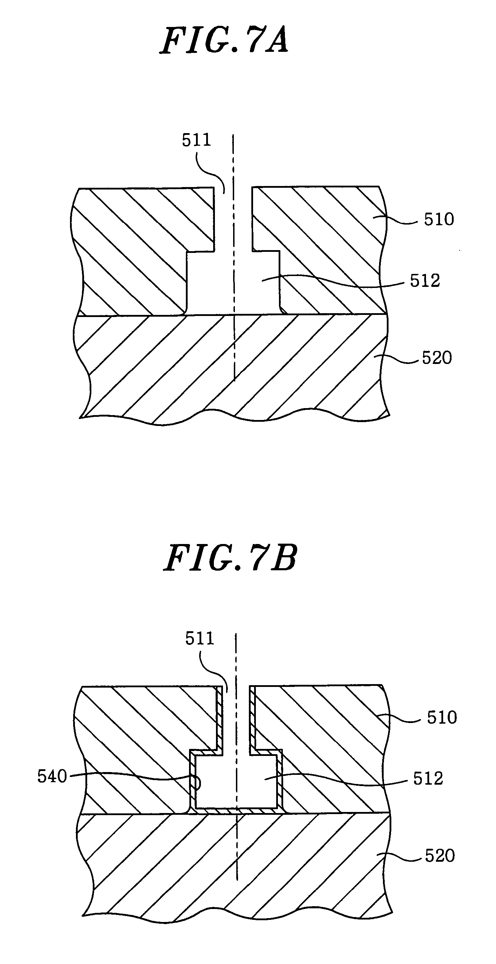

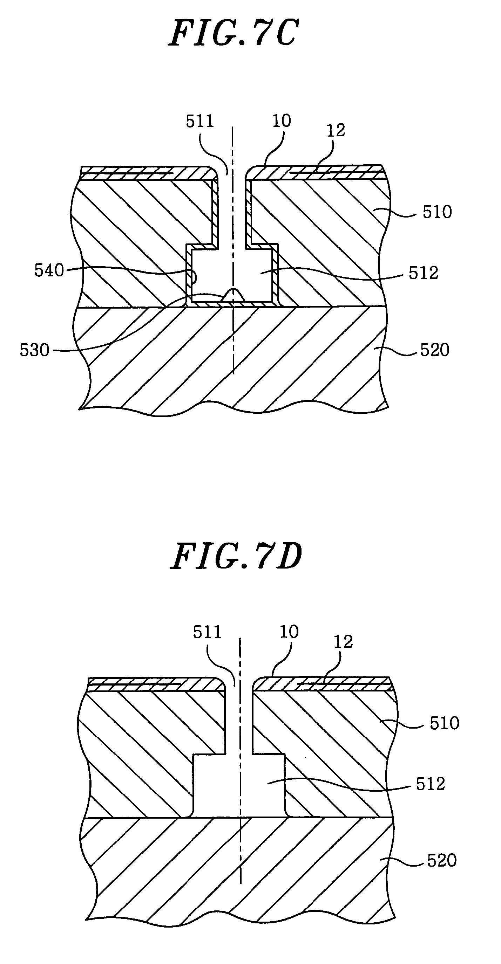

Hereinafter, a manufacturing method of the substrate mounting table 5 will be explained with reference to Figs. 6 and 7. In the following, though the manufacturing method is described for the case of using the first plate shaped member 510 prepared by forming the gas injection openings 511, the grooves 512 and the pin holes 513 in a circular plate made of aluminum and the second plate member 520 prepared by forming the pin holes 523, the gas supply openings 524 and the cleaning openings 525 in a circular plate made of aluminum, it is to be noted that the present invention is not limited thereto.

As described in Fig. 6, the first plate shaped member 510 and the second plate shaped member 520 are welded together through, for example, a soldering process (step S101). Then, by an anodic oxidation process (alumite process), an anodic oxide film (alumite film) is formed on inner surfaces of the gas injection openings 511 and the portions serving as the gas supply channel including inner surfaces of the groove 512 (step S102). This state is shown in Fig. 7A.

Then, a removable film 540 is formed at least on inner wall portions of the grooves 512 (bottom portions of the grooves 512, i.e., a top surface of the second plate shaped member 520), which face the gas injection openings 511 (step S103). In the present embodiment, the removable film 540 is formed not only on the inner wall portions of the grooves 512 facing the gas injection openings 511 but also on the remaining inner wall portions of the grooves 512 and the inner surfaces of the gas injection openings 511, as shown in Fig. 7B,. The removable film 540 may be made of, for example, resin and, preferably, it can be made of acrylic resin. Furthermore, the removable film 540 can be formed by a method of, for example, injecting liquid acrylic resin into the gas supply channel through the gas supply openings 524, cleaning openings 525, and so forth.

Subsequently, while supplying a gas such as compressed air through the gas supply openings 524, the cleaning openings 525 and so forth and ejecting the gas through the gas injection openings 511, ceramic such as Al₂O₃ is thermally sprayed on the mounting surface (step S104). Then, a thermally sprayed ceramic film 10, a thermally sprayed metal film (electrode) 12, and a thermally sprayed ceramic film 10 are sequentially deposited on the mounting surface, thereby forming the electrostatic chuck 11 with triple layers. At this time, though it is difficult for the thermally sprayed ceramic to enter the gas injection openings 511 due to the ejection of the gas, some of the thermally sprayed ceramic may nevertheless enter the gas injection openings 511 and stick to the surface of the removable film 540 on the bottom portions of the grooves 512 in the form of a lump 530 as shown in Fig. 7C.

Thereafter, by introducing a fluid, for example, an organic solvent such as acetone, compressed air or water, into the grooves 512, removal of the film 540 and cleaning is performed (step S105), so that the lump 530 of the thermally sprayed ceramic stuck during the ceramic spraying process is removed. This cleaning process is carried out by using the cleaning openings 525 and the gas supply openings 524 shown in Fig. 5 and can be implemented by an appropriate combination of an air purging step using the compressed air, a step of simultaneously performing an air purging using the compressed air and flowing a water through the grooves 512, an immersion step using a solvent such as acetone, and the like. At this time, since the thermally sprayed ceramic that has entered the gas injection openings 511 is stuck to the surface of the film 540, the lump 530 of the thermally sprayed ceramic can be readily removed by removing the film 540, thus greatly reducing the probability of the presence of spray residue, in comparison with conventional cases. The state upon the completion of the film removing process and the cleaning process illustrated in Fig. 7D.

In practice, by using acrylic resin as the film 540, the cleaning process including an immersion step of removing the film 540 by using acetone and an air purging step was performed after the ceramic spraying process, and it was revealed that the ceramic lump 530 can be all removed, so that the number of residual ceramic lumps 530 in the grooves 512 is counted zero. Meanwhile, in a comparative example in which no film 540 is formed, six lumps 530 of thermally sprayed ceramic were found to remain after the cleaning process, even though the cleaning was carried out by performing the air purging step, the step of simultaneously performing the air purging and flowing the water through the grooves 512, an acetone immersion step, the air purging step, and the step of simultaneously performing the air purging and flowing the water through the grooves 512 in sequence.

In accordance with the present embodiment described above, a stay of spray residue inside the cooling gas supply channel can be prevented, so that contamination by the spray residue or clogging-up of the fluid supply channel with the spray residue can be avoided. Further, it is to be noted that the present invention can be modified in various ways without being limited to the present embodiment. For example, though the present invention is applied to the manufacture of the substrate mounting table of the plasma etching apparatus in the above embodiment, the present invention can also be applied to the manufacture of substrate mounting tables of various types of substrate processing apparatus such as a CVD apparatus.

While the invention has been shown and described with respect to the embodiment, it will be understood by those skilled in the art that various changes and modification may be made without departing from the scope of the invention as defined in the following claims.

## Claims

1. A method for manufacturing a substrate mounting table including a mounting surface for mounting a substrate thereon; a plurality of gas injection openings opened on the mounting surface to supply a gas toward the mounting surface; a gas supply channel for supplying a gas to the gas injection openings; and a thermally sprayed ceramic layer covering the mounting surface, the method comprising:
forming a removable film at least on inner wall portions of the gas supply channel facing the gas injection openings;
forming the thermally sprayed ceramic layer on the mounting surface; and
removing the film.

2. The method of claim 1, wherein, in forming the thermally sprayed ceramic layer, ceramic is thermally sprayed on the mounting surface while discharging a compressed gas from the gas injection openings.

3. The method of claim 1 or 2, wherein the gas supply channel is shared by the gas injection openings.

4. The method of any one of claims 1 to 3, wherein the film is made of acrylic resin.

5. The method of claim 4, wherein, in removing the film, the film is removed by using an organic solvent.

6. The method of claim 5, wherein the organic solvent is acetone.

7. The method of any one of claims 1 to 6, further comprising:
preparing in the gas supply channel a plurality of cleaning openings for introducing into or exhausting from the gas supply channel a cleaning fluid,
wherein in removing the film, the cleaning fluid is introduced into or exhausted from the gas supply channel through the cleaning openings.
